# EUROPEAN PATENT SPECIFICATION

(11) **EP 2 876 457 B1**
(45) Date of publication and mention of the grant of the patent: **14.09.2016**
(21) Application number: 12866984.3
(22) Date of filing: 17.10.2012
(51) Int. Cl.: B25J 5/00, G01R 35/04, B65B 5/00

(54) **ELECTRICAL ENERGY METER VERIFICATION SYSTEM AND ROBOT THEREFOR**
ÜBERPRÜFUNGSSYSTEM FÜR EIN STROMMESSGERÄT UND ROBOTER DAFÜR
SYSTÈME DE VÉRIFICATION DE COMPTEUR D'ÉNERGIE ÉLECTRIQUE ET ROBOT ASSOCIÉ

(30) Priority: 20.07.2012 CN 201210253398
(43) Date of publication of application: 27.05.2015
(73) Proprietor: Chongqing Electric Power Research Institute, Chongqing 401123 (CN); MIANYANG GOCREAT TECHNOLOGY CO., LTD., Sichuan 621006 (CN)
(72) Inventor: HE, Jianjun, Chongqing 401123 (CN); HOU, Xingzhe, Chongqing 401123 (CN); OU, Xiyang, Chongqing 401123 (CN); ZHENG, Ke, Chongqing 401123 (CN); ZHOU, Quan, Chongqing 401123 (CN); LI, Linxia, Chongqing 401123 (CN); WU, Hua, Chongqing 401123 (CN); HU, Xiaorui, Chongqing 401123 (CN); HU, Tianlian, Chongqing 401123 (CN); WU, Jian, Mianyang, Sichuan 621006 (CN); CHEN, Gang, Mianyang, Sichuan 621006 (CN)
(74) Representative: Maikowski & Ninnemann Patentanwälte Partnerschaft mbB
(86) International application number: PCT/CN2012/083064
(87) International publication number: WO 2014/012304

(56) References cited:
- EP-A1- 2 082 851
- WO-A1-2009/054778
- CN-A- 102 183 738
- CN-A- 102 360 068
- CN-A- 102 360 068
- CN-A- 102 565 747
- CN-U- 201 749 183
- CN-U- 202 174 585
- CN-U- 202 174 585
- JP-A- H11 274 264

## Description

This application claims the benefit of priority to Chinese patent application No. 201210253398.0 titled "ELECTRICITY METER VERIFICATION SYSTEM AND ELECTRICITY METER VERIFICATION ROBOT" and filed with the Chinese State Intellectual Property Office on July 20, 2012.

### FIELD OF THE INVENTION

The present application relates to the technical field of the electricity meter verification apparatus, and more particularly to an electricity meter verification system and an electricity meter verification robot

### BACKGROUND OF THE INVENTION

With the construction of the smart grid and the transformation of one meter per household, the demand for the electricity meter is greatly increased. In accordance with the Metrology Law of the People's Republic of China, for ensuring the accuracy of the electricity meter, it requires to verify the electricity meter periodically.

Currently, the processes for verifying the electricity meter are performed manually either in the electricity meter manufacturer or in the electricity meter verification institution. The verifying of the electricity meter is mainly performed manually to finish the splitting and reorganizing of the meter box, the hanging of the meter, the picking of the meter and the verifying of the meter. The manual operation method requires a large amount of labor and has a low operation efficiency, and the verifying qualities are various, therefore it is difficult to meet the requirements for the electricity meter verification of the society, and it is difficult to meet the demands for the industrialization and large-scale of the verification. CN 202174585 U discloses a robot loading and unloading device for an electric energy meter, which solves the technical problem that loading and unloading of current electric energy meter is still operated manually with low efficiency. The utility model comprises a meter box transport chain, a tool plate transport chain and an empty box buffering chain. A multiple shaft linkage mechanical arm is arranged among the meter box transport chain, the tool plate transport chain and the empty box buffering chain. The mechanical arm is provided with a conversion adapter, and a paper box clamp and an electric energy meter sucking disc are respectively provided with conversion interfaces matched with the conversion adapter. The paper box clamp and the electric energy meter sucking disc are placed in a changing table. An electric energy meter transferring table is arranged at one side of the mechanical arm. The transferring table is provided with an electric energy meter positioning bump. The utility model re-positions the electric energy meter precisely, eliminates the impact of tolerance of an inner model of the meter box, reduces the mobile error, improves the placing precision of the electric energy meter on the tool plate and has high clamping reliability, improves the production efficiency and is suitable for application and use in a large range.

Therefore, there is an urgent demand for the person skilled in the art to improve the speed of the verifying of an electricity meter, reduce the manual labor intensity and improve the working efficiency.

### SUMMARY OF THE INVENTION

In view of this, it is provided according to the present application an electricity meter verification robot so as to increase the speed of the verifying of the electricity meter, reduce the manual labor intensity and thus to improve the working efficiency. It is further provided according to the present application an electricity meter verification system having the above electricity meter verification robot.

For achieving the above objects, the present application provides the following technical solutions.

The present application provides an electricity meter verification robot including:
a chassis;
an electricity meter turnover box-picking and placing mechanism provided on the chassis for picking and placing an electricity meter turnover box;
a mechanical hand for picking, placing and verifying an electricity meter; and
a mechanical arm provided on the chassis for controlling a position of the mechanical hand, and the mechanical hand is arranged at an end of the mechanical arm away from the chassis.

Thereby, the electricity meter turnover box-picking and placing mechanism includes:
a telescopic clamping unit for clamping the electricity meter turnover box; and
a lift unit connected to the telescopic clamping unit for lifting or lowering the telescopic clamping unit.

Preferably, the electricity meter verification robot further includes a control cabinet which is in communication with the chassis, the electricity meter turnover box-picking and placing mechanism, the mechanical hand and the mechanical arm.

Preferably, the control cabinet includes a control component for sending a control signal and an energy supply device for supplying electric energy. The control component and the energy supply device are connected to the chassis, the electricity meter turnover box-picking and placing mechanism, the mechanical hand and the mechanical arm via cables.

Preferably, the control cabinet includes a control component for sending a control signal, and the control component is in wireless communication connection with the chassis, the electricity meter turnover box-picking and placing mechanism, the mechanical hand and the mechanical arm. The chassis is provided with a power supply device for supplying electric energy.

Preferably, the power supply device is a storage battery, and the control cabinet is provided with a charging device for charging the storage battery.

Preferably, the telescopic clamping unit includes:
two clamping assemblies for clamping two sides of the electricity meter turnover box, with clamping directions of the two clamping assemblies being arranged opposite to each other; and
a telescopic carrying assembly connected to the lift unit for driving the clamping assemblies to extend or retract.

Preferably, the telescopic carrying assembly includes two carrying arms and a supporting frame fixedly connected to ends of the two carrying arms located on the same side. The two clamping assemblies are provided on the two carrying arms, respectively and are slideable on the two carrying arms synchronously.

Preferably, the carrying arm includes:
a housing slidably cooperated with the clamping assembly, and the housing is slidably connected to the supporting frame;
a pulling rope for pulling the clamping assembly to slide with respect to the housing, with two ends of the pulling rope being fixedly connected with the supporting frame; and
a driving unit for driving the housing to slide with respect to the supporting frame.

Preferably, the driving unit includes:
a rack provided on the housing;
a transmission gear provided on the supporting frame and engaged with the rack; and
a first slide driving device for driving the transmission gear to rotate.

Preferably, a fixed slider is provided at a top end of the supporting frame, and the fixed slider is cooperated with and slides in a slide rail provided at a lower end of the housing.

Preferably, the clamping assembly includes:
a box-clamping seat provided on the carrying arm; and
two clamping units provided in the box-clamping seat for clamping a front surface and a back surface of the electricity meter turnover box, respectively.

Preferably, the clamping unit includes:
a first driving device provided in the box-clamping seat;
a slider provided in the box-clamping seat and driven by the first driving device to slide along an inside of the box-clamping seat; and
an articulated rod, one end of which is articulated with the slider, and the other end of the articulated rod is articulated with a clamping claw which is configured for abutting against the electricity meter turnover box, and the box-clamping seat is formed with a receiving groove for receiving the clamping claw.

Preferably, the lift unit includes:
a support;
a screw rod provided on the support, and a lift nut is provided on the telescopic clamping unit for cooperating with the screw rod through threads;
a fixing base provided at a top end of the screw rod for fixedly connecting the chassis, and the fixing base is slidably cooperated with the telescopic clamping unit along an extending direction of the screw rod; and
a driving component provided on the support for driving the screw rod to rotate.

Preferably, the fixing base is provided with a lift slider, and the telescopic clamping unit is provided with a lift slideway cooperated with the lift slider.

Preferably, the mechanical hand includes:
a base;
an integrated claw provided on the base for clamping an IC card and the electricity meter;
a cover-turning device provided on the base for opening or closing an electricity meter programming cover; and
a screwing device provided on the base for screwing a screw and pressing a programming button.

Preferably, the integrated claw includes:
a first clamping finger and a second clamping finger for clamping two sides of the electricity meter and the IC card, respectively; and
a second driving device fixedly connected to the base for driving the first clamping finger and the second clamping finger to perform clamping motions.

Preferably, one end of the first clamping finger is provided with a first IC card-clamping end, and the other end of the same is provided with a first electricity meter-clamping end; and
one end of the second clamping finger is provided with a second IC card-clamping end for cooperating with the first IC card-clamping end to clamp the IC card, and the other end of the second clamping finger is provided with a second electricity meter-clamping end for cooperating with the first electricity meter-clamping end to clamp the electricity meter.

Preferably, the screwing device includes:
a screwdriver matched with a screw on the electricity meter programming cover;
a driving element fixedly provided on the base for driving the screwdriver to rotate; and
a supporting component connected to the integrated claw in a snap fit manner for supporting the screwdriver.

Preferably, the cover-turning device includes:
a sucking disk for sucking the electricity meter programming cover;
a fixing arm connected to the base;
a rotating arm, one end of which is articulated with the fixing arm; and
a connecting arm articulated with the other end of the rotating arm, and the sucking disk is fixedly provided at one end of the connecting arm away from the rotating arm.

Preferably, the mechanical hand further includes:
an infrared communication device provided on the base for verifying the infrared communication performance of the electricity meter; and
a video capture device provided on the base for capturing information of the electricity meter.

Preferably, the mechanical hand further includes a protection cover provided on the base, and the protection cover is provided with a connecting end for connecting the mechanical arm.

Preferably, the mechanical arm includes:
a first connecting end rotatably connected to the chassis;
a first connecting arm, one end of which is articulated with the first connecting end;
a second connecting end articulated with the other end of the first connecting arm;
a second connecting arm rotatably connected to the second connecting end; and
a third connecting end articulated with the second connecting arm, and the third connecting end is rotatably connected to the mechanical hand.

Preferably, the electricity meter verification robot further includes a rail slidably cooperated with the chassis such that the chassis is moved in a predetermined direction.

It is further provided according to the present application an electricity meter verification system including: an electricity meter verification platform having an electricity meter verification station, and an electricity meter verification robot as described above. The electricity meter verification robot is cooperated with the electricity meter verification platform.

It can be seen from the above technical solutions that, the electricity meter verification robot according to the present application includes: a chassis; an electricity meter turnover box-picking and placing mechanism provided on the chassis for picking and placing an electricity meter turnover box; a mechanical arm provided on the chassis; a mechanical hand provided at one end of the mechanical arm away from the chassis for picking, placing and verifying an electricity meter; wherein the electricity meter turnover box-picking and placing mechanism comprises a telescopic clamping unit for clamping the electricity meter turnover box and a lift unit connected to the telescopic clamping unit for lifting or lowering the telescopic clamping unit.

The electricity meter turnover box is placed on the chassis by the electricity meter turnover box-picking and placing mechanism, and then the mechanical hand is controlled by the mechanical arm such that the electricity meter is taken out of the electricity meter turnover box and is placed on the electricity meter verification station for being verified, and the electricity meter is placed back into the electricity meter turnover box after having been verified. With the electricity meter verification robot according to the embodiment of the present application, the electricity meter is automatically picked, placed and verified, which effectively improves the speed of the verifying of the electricity meter, and the labor intensity is reduced. Therefore the working efficiency is improved.

Since the electricity meter verification system according to the present application includes the above electricity meter verification robots, the electricity meter verification system has the same technical effects as those of the above electricity meter robots, which will not be introduced in detail.

### BRIEF DESCRIPTION OF THE DRAWINGS

In order to clearly illustrate embodiments of the present application or technical solutions in the prior art, drawings required for the description of the embodiments or the prior art will be briefly introduced below. Apparently, drawings described below are simply some embodiments of the present application, and those skilled in the art may also obtain other drawings, based on the followed drawings, without any creative work.
Figure 1 is a structural schematic view of an electricity meter verification robot according to an embodiment of the present application;
Figure 2 is an exploded schematic view of an electricity meter verification robot according to an embodiment of the present application;
Figure 3 is an operational schematic view showing that the electricity meter verification robot according to the embodiment of the present application is picking an electricity meter turnover box;
Figure 4 is an operational schematic view showing that the electricity meter verification robot according to the embodiment of the present application is picking an electricity meter in the electricity meter turnover box;
Figure 5 is an operational schematic view showing that the electricity meter verification robot according to the embodiment of the present application is verifying an electricity meter;
Figure 6 is an operational schematic view of an electricity meter-picking and placing mechanism according to an embodiment of the present application;
Figure 7 is a schematic view showing a zero position of an electricity meter-picking and placing mechanism according to the embodiment of the present application;
Figure 8 is a structural schematic view of a telescopic clamping unit according to an embodiment of the present application;
Figure 9 is an exploded view of the telescopic clamping unit according to the embodiment of the present application;
Figure 10 is a structural schematic view of the telescopic clamping unit according to an embodiment of the present application, with the telescopic clamping unit being retracted.
Figure 11 is a structural schematic view of the telescopic clamping unit according to the embodiment of the present application, with the telescopic clamping unit being extended.
Figure 12 is an exploded view of a carrying arm according to an embodiment of the present application;
Figure 13 is an exploded view of a driving unit and a supporting frame according to an embodiment of the present application;
Figure 14 is an exploded schematic view of a clamping unit according to an embodiment of the present application;
Figure 15 is a sectional view of the clamping unit according to an embodiment of the present application, with the clamping unit being retracted;
Figure 16 is a sectional view of the clamping unit according to the embodiment of the present application, with the clamping unit being in operation;
Figure 17 is an exploded view of a lift unit according to an embodiment of the present application;
Figure 18 is a structural schematic view of the lift unit according to the embodiment of the present application;
Figure 19 is a structural schematic view of a mechanical hand according to an embodiment of the present application;
Figure 20 is an exploded view of the mechanical hand according to the embodiment of the present application;
Figure 21 is a structural schematic view of an integrated claw according to an embodiment of the present application;
Figure 22 is an operational schematic view showing that the mechanical hand according to an embodiment of the present application is picking an electricity meter;
Figure 23 is an operational schematic view showing that the mechanical hand according to the embodiment of the present application is picking an IC card;
Figure 24 is an operational schematic view showing that the mechanical hand according to the embodiment of the present application is screwing a screw;
Figure 25 is a structural schematic view of a cover-turning device according to an embodiment of the present application; and
Figure 26 is an operational schematic view showing that the mechanical hand according to the embodiment of the present application is turning the cover and pressing a programming button.

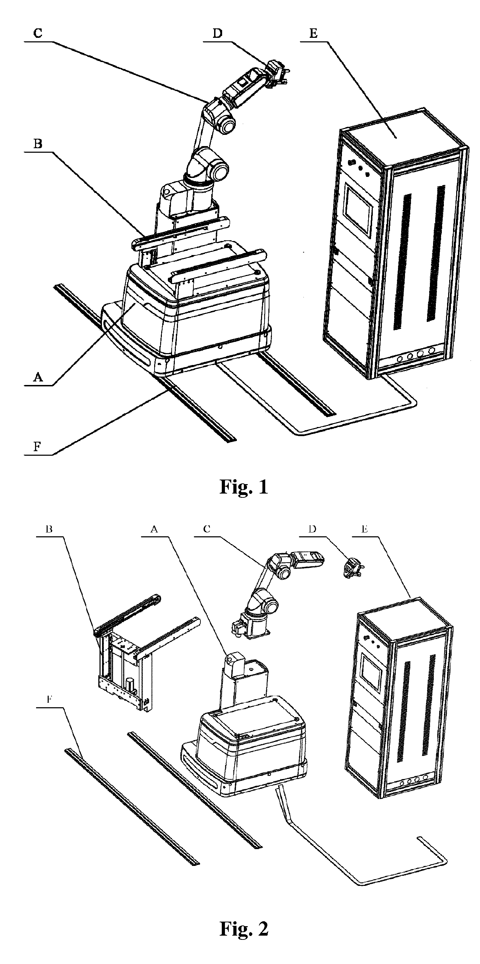

Reference numerals in Figures 1 to 26:
A-chassis, B-electricity meter turnover box-picking and placing mechanism, B1-clamping assembly, B11-box clamping seat, B12-clamping unit, B121-first driving device, B122-slider, B123-articulated rod, B124-clamping claw, B13-guide slider, B14-first detection sensor, B2-carrying arm, B21-house, B22-pulling rope, B23-driving unit, B231-rack, B232-transmission gear, B233-slide driving device, B24-fixed slider, B25-slide rail, B26-guide rail, B27-first pulley, B28-second pulley, B3-supporting frame, B31-lift slideway, B32-second detection sensor, B4-third detection sensor, B5-support, B6-screw rod, B7-lift nut, B8-fixing base, B81-lift slider, B9-driving component, B10-fourth detection sensor, C-mechanical arm, D-mechanical hand, D1-base, D2-integrated claw, D21-first clamping finger, D22-second clamping finger, D23-second driving device, D3-cover-turning device, D31-sucking disk, D32-fixing arm, D33-rotating arm, D34-connecting arm, D4-screwing device, D5-infrared communication device, D6-video capture device, D7-protection cover, E-controlling cabinet, F-rail, G-electricity meter turnover box, K-electricity meter, L-IC card.

### DETAILED DESCRIPTION

It is provided according to the present application an electricity meter verification robot so as to improve the speed of the verifying of an electricity meter, reduce the manual labor intensity and further improve the operation efficiency. The present application further provides an electricity meter verification system having the above electricity meter verification robot.

Technical solutions in embodiments of the present application will be clearly and fully described below in conjunction with the accompanying drawings in the embodiments of the present application. Apparently, the described embodiments are only a part, but not all, of the embodiments of the present application. All other embodiments defined by the appended claims fall within the protection scope of the present application.

Referring to Figure 1 and Figure 2, Figure 1 is a structural schematic view of an electricity meter verification robot according to an embodiment of the present application, and Figure 2 is an exploded schematic view of an electricity meter verification robot according to an embodiment of the present application.

It is provided according to an embodiment of the present application an electricity meter verification robot including: a chassis A; an electricity meter turnover box-picking and placing mechanism B provided on the chassis A for picking and placing an electricity meter turnover box; a mechanical hand D for picking, placing and verifying an electricity meter; and a mechanical arm C provided on the chassis A for controlling the position of the mechanical hand D. The mechanical hand D is arranged at an end of the mechanical arm C away from the chassis

With the electricity meter verification robot according to the embodiment of the present application, the electricity meter turnover box is placed on the chassis A by the electricity meter turnover box-picking and placing mechanism B, and the mechanical hand D is controlled by the mechanical arm C such that the electricity meter is taken out of the electricity meter turnover box and placed on an electricity meter verification station for being verified, and the electricity meter is placed back into the electricity meter turnover box after the verification is finished. With the electricity meter verification robot according to the embodiment of the present application, the electricity meter is picked and placed automatically and then is verified, which effectively increases the speed of the verifying of the electricity meter, reduces the labor intensity, and therefore improves the working efficiency.

For verifying an electricity meter automatically, the electricity meter verification robot according to the present application further includes a control cabinet E which is in communication connection with the chassis A, the electricity meter turnover box-picking and placing mechanism B, the mechanical hand D and the mechanical arm C.

Preferably, the control cabinet E has a control component for sending a control signal and an energy supply device for providing electric energy. The control component and the energy supply device are connected to the chassis A, the electricity meter turnover box-picking and placing mechanism B, the mechanical hand D and the mechanical arm C via cables.

In the operation process of the electricity meter verification robot according to the embodiment of the present application, the control component of the control cabinet E is in communication connection with the chassis A, the electricity meter turnover box-picking and placing mechanism B, the mechanical hand D and the mechanical arm C via cables and sends control signals to the same, therefore the chassis A, the electricity meter turnover box-picking and placing mechanism B, the mechanical hand D and the mechanical arm C are controlled to perform corresponding operations to the electricity meter and the electricity meter turnover box. Meanwhile motion energy is supplied by the energy supply device of the control cabinet E to the chassis A, the electricity meter turnover box-picking and placing mechanism B, the mechanical hand D and the mechanical arm C. That is, by the connection with the control cabinet E via cables, energy is supplied and control signals are sent to the chassis A, the electricity meter turnover box-picking and placing mechanism B, the mechanical hand D and the mechanical arm C.

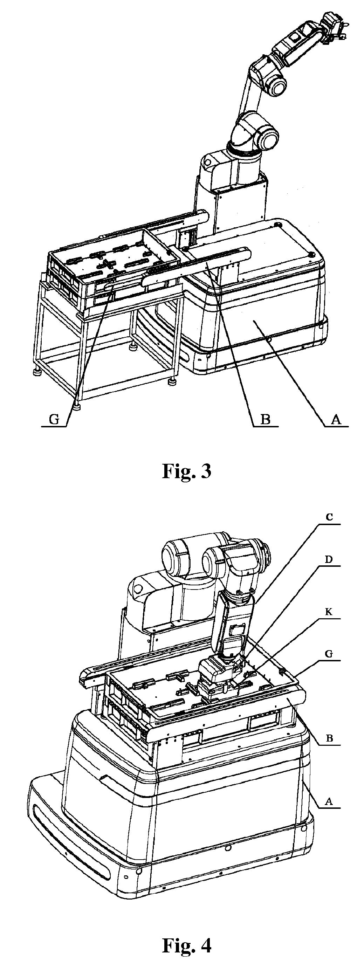

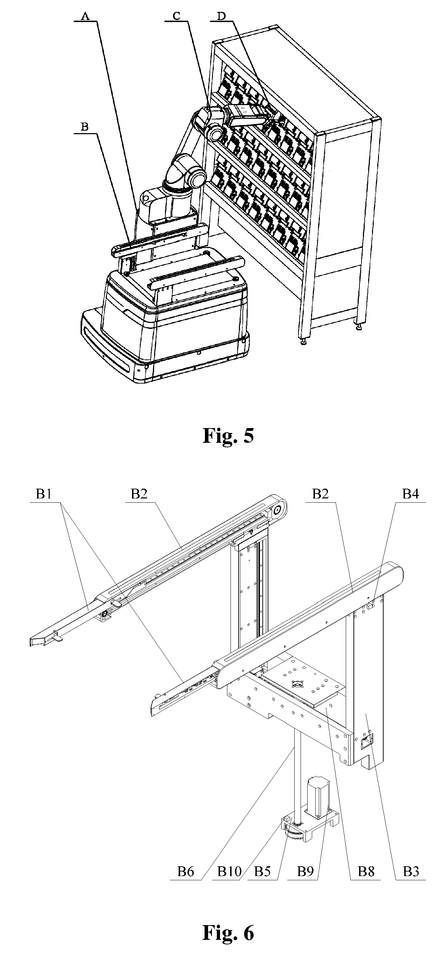

Referring to Figure 3, Figure 4, and Figure 5, Figure 3 is an operational schematic view showing that the electricity meter verification robot according to the embodiment of the present application is picking an electricity meter turnover box; Figure 4 is an operational schematic view showing that the electricity meter verification robot according to the embodiment of the present application is picking an electricity meter in the electricity meter turnover box; and Figure 5 is an operational schematic view showing that the electricity meter verification robot according to the embodiment of the present application is verifying an electricity meter.

The chassis A is preferably configured as a platform which is movable automatically. The chassis A is connected to the control cabinet E via cables such that electricity can be supplied to the chassis A and communication between the two components can be established. With the moving of the chassis A, the electricity meter verification robot according to the embodiment of the present application is brought close to the position at which the electricity meter turnover box is placed and the electricity meter verification station. After the chassis A is near to the position at which the electric energy turnover box is placed, the control cabinet E is in communication connection with the electricity meter turnover box-picking and placing mechanism B via cables, such that the electricity meter turnover box-picking and placing mechanism B picks the electricity meter turnover box under the control of the control cabinet E. The control cabinet E is brought into communication with the mechanical hand D and the mechanical arm C via cables, therefore the mechanical arm C is controlled such that the mechanical hand D is close to the electricity meter in the electricity meter turnover box, and then the mechanical hand D is controlled to pick the electricity meter. Through the moving of the chassis A controlled by the control cabinet E, the electricity meter verification robot according to the embodiment of the present application is brought to be close to the electricity meter verification station, and by controlling the mechanical hand D and the mechanical arm C to act cooperatively, the electricity meter is placed on the verification station and is verified.

Known from the above, the control cabinet E controls the mechanical hand D and the mechanical arm C to act cooperatively such that a verified electricity meter is placed back into the electricity meter turnover box, and then the electricity meter turnover box is placed back to a predetermined position for the electricity meter turnover box by the electricity meter turnover box-picking and placing mechanism B, detailed description of which will be omitted herein.

The control cabinet E may be provided with a control component for sending a control signal, and the control component is in wireless communication connection with the chassis A, the electricity meter turnover box-picking and placing mechanism B, the mechanical hand D and the mechanical arm C. The chassis A is provided with a power supply device for providing electric energy. The power supply device may be a storage battery, and may provide electric energy to the chassis A, the electricity meter turnover box-picking and placing mechanism B, the mechanical hand D and the mechanical arm C via cables provided inside. It is to be noted that, to simplify the structure of the device, the power supply device according to the present embodiment is arranged in the chassis A. A plurality of energy supplying devices may be provided to supply energy to the chassis A, the electricity meter turnover box-picking and placing mechanism B, the mechanical hand D and the mechanical arm C, respectively.

Preferably, a storage battery is employed as the power supply device, and the control cabinet E is provided with a charging device for charging the storage battery. When the storage battery is to be charged, the electricity meter verification robot is moved to be adjacent to the control cabinet E, and the storage battery is connected to the charging device and thus is charged.

The control cabinet E may be provided with a control component for sending a control signal and an energy supply device for providing electric energy. The control component is in wireless communication connection with the chassis A, the electricity meter turnover box-picking and placing mechanism B, the mechanical hand D and the mechanical arm C. The energy supply device is connected to the chassis A, the electricity meter turnover box-picking and placing mechanism B, the mechanical hand D and the mechanical arm C via cables to supply energy. Alternatively, the control cabinet E is provided with a control component for sending a control signal, and an energy supply device is provided on the chassis A. The control component is in communication connection with the chassis A, the electricity meter turnover box-picking and placing mechanism B, the mechanical hand D and the mechanical arm C via cables and sends control signals to the same, all of which fall within the protection scope.

The electricity meter turnover box-picking and placing mechanism B according to an embodiment of the present application includes: a telescopic clamping unit for clamping the electricity meter turnover box, and a lift unit connected to the telescopic clamping unit for lifting or lowering the telescopic clamping unit.

As shown in Figure 3, in the clamping process, the clamping end is extended, through an extending motion, to the position at which the electric energy turnover box is placed to clamp the electricity meter turnover box G, and then the electricity meter turnover box G is moved horizontally through a retraction motion. After being picked and placed horizontally, the electricity meter turnover box G is moved vertically through the lifting and lowering motions of the lift unit, and then is placed on a predetermined station by the lift unit. The picking and placing of the electricity meter turnover box G is performed with the cooperation of the lift unit and the telescopic clamping unit, thereby the manual operation is avoided, the manual labor intensity is greatly reduced, and the working efficiency is improved.

The above predetermined station refers to an operation platform provided on the chassis A for placing the electricity meter turnover box G. Since the mechanical arm C is arranged on the chassis A and is further connected to the mechanical hand D, with the arrangement of the electricity meter turnover box G on the chassis A, it is convenient for the mechanical hand D to pick and place the electricity meter in the electricity meter turnover box G.

It is to be noted that, the electricity meter turnover box-picking and placing mechanism B may pick and place one or more than one electricity meter turnover box G at a time. Taking the case in which two electricity meter turnover boxes G are picked and placed for instance, a second electricity meter turnover box G of the electricity meter turnover boxes stacked from top to bottom at the stacking area is clamped by the telescopic clamping unit of the electricity meter turnover box-picking and placing mechanism B. That is, in the picking and placing processes, a first electricity meter turnover box G stacked on the second electricity meter turnover box G is also picked and placed.

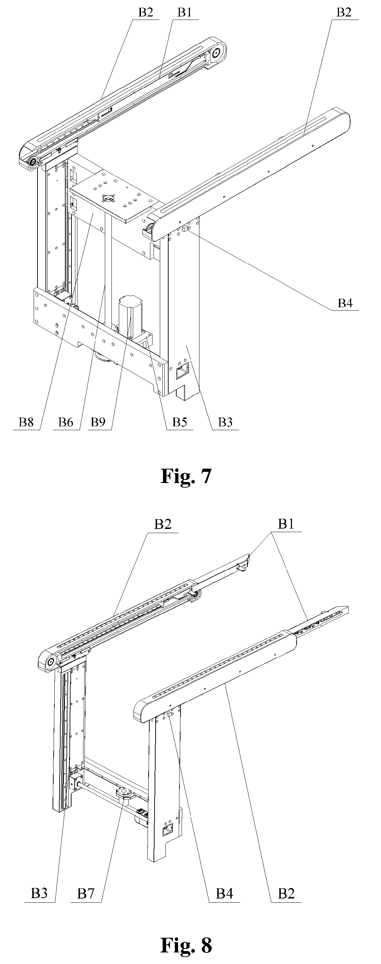

Referring to Figure 6 and Figure 7, the telescopic clamping unit includes: two clamping assemblies B1 for clamping two sides of the electricity meter turnover box, with clamping directions of the two clamping assemblies B1 being arranged opposite to each other; and a telescopic carrying assembly connected to the lift unit for driving the clamping assemblies B1 to extend or retract. In the clamping process, the two clamping assemblies B1 are extended to the two sides of the electricity meter turnover box through the extending motion of the telescopic carrying assembly, the electricity meter turnover box is clamped between the two clamping assemblies B1 by the two clamping assemblies B1 whose clamping directions are arranged opposite to each other, and the electricity meter turnover box is picked and placed horizontally by the retracting motion of the telescopic carrying assembly. With the arrangement of the two clamping assemblies B1 for clamping two sides of the electricity meter turnover box, the clamping smoothness of the telescopic clamping unit in the course that the electricity meter turnover box is clamped by the telescopic clamping unit is improved.

Alternatively, there may be only one clamping assembly B1, and an extending arm is provided corresponded to the clamping direction of the clamping assembly B1. The electricity meter turnover box is clamped between the clamping assembly B1 and the extending arm by the clamping motion of the clamping assembly B1, thus the electricity meter turnover box is clamped with the same effects.

As shown in Figure 8, the telescopic carrying assembly includes: two carrying arms B2, and a supporting frame B3 fixedly connected to ends of the two carrying arms B2 located on the same side. The two clamping assemblies B1 are provided on the two carrying arms B2, respectively, and are slideable thereon synchronously. Through the synchronous sliding of the two clamping assemblies B1, two sides of the electricity meter turnover box can be clamped synchronously, which can prevent the offsetting of the electricity meter turnover box while being clamped.

Alternatively, there may be only B1 clamping arm B2, the two clamping assemblies 1 are connected via a third component. The third component is slidably connected to the supporting arm 2, so as to achieve the same effects.

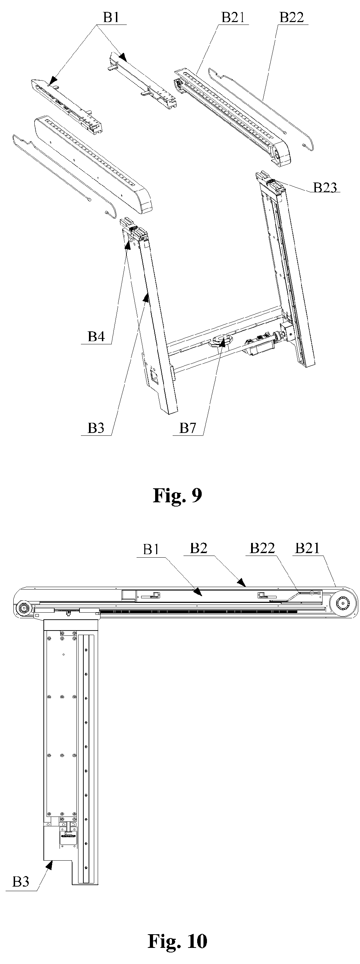

As shown in Figure 9, the carrying arm B2 includes: a housing B21 slidably cooperated with the clamping assembly B1 and the housing B21 is slidably connected to the supporting frame B3; a pulling rope B22 for pulling the clamping assembly B1 to slide with respect to the housing B21, with two ends of the pulling rope B22 being fixedly connected with the supporting frame B3; and a driving unit B23 for driving the housing B21 to slide with respect to the supporting frame B3.

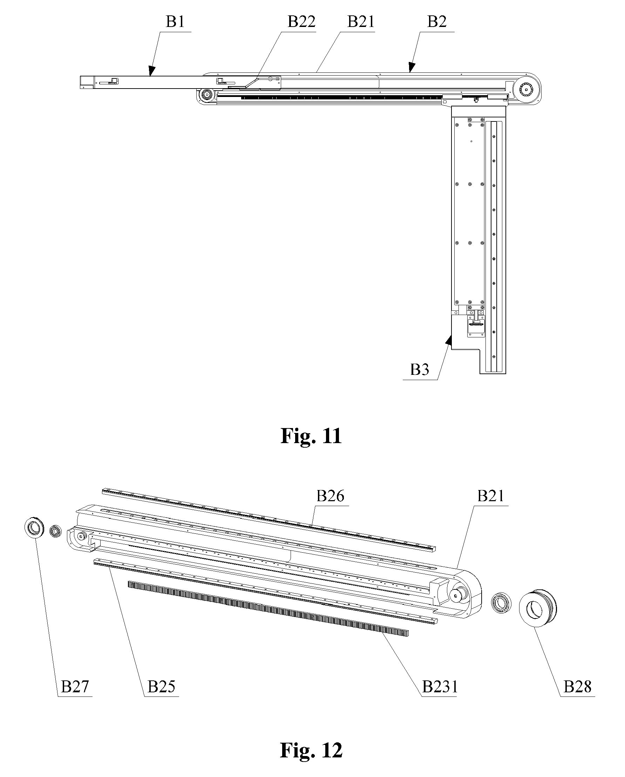

Referring to Figure 10 and Figure 11, Figure 10 is a structural schematic view of the telescopic clamping unit according to an embodiment of the present application, with the telescopic clamping unit being retracted. Figure 11 is a structural schematic view of the telescopic clamping unit according to the embodiment of the present application, with the telescopic clamping unit being extended.

The pulling rope B22 is fixedly connected with the distal end of the clamping assembly B1, with two ends of the pulling rope being fixed to the supporting frame B3 to form an annular structure surrounding the clamping assembly B1. When the housing B21 is driven by the driving unit B23 to slide with respect to the supporting frame B3, since two ends of the pulling rope B22 is fixedly connected to the supporting frame B3, the annular structure formed by the pulling rope B22 is rolled towards the moving direction of the housing B21, which in turn drives the distal end of the clamping assembly B1 to slide in the housing B21, thus the clamping assembly B1 is extended or retracted.

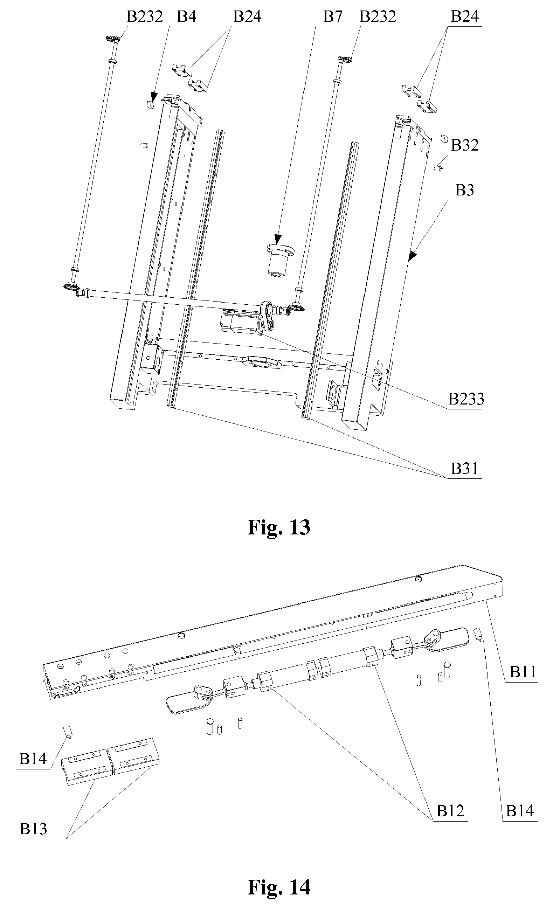

In the embodiment of the present application, the driving unit B23 includes: a rack B231 provided on the housing B21; a transmission gear B232 arranged on the supporting frame B3 and engaged with the rack B231; and a first slide driving device B233 for driving the transmission gear B232 to rotate. As shown in Figure 12 and Figure 13, the transmission gear B232 is driven by the first slide driving device B233 to rotate. Since the transmission gear B232 is engaged with the rack B231 on the housing B21, the housing B21 is driven to move with respect to the transmission gear B232; and since the transmission gear B232 is arranged on the supporting frame B3, the housing B21 is driven to slide horizontally with respect to the supporting frame B3.

In the present embodiment, the first slide driving device B233 includes a motor and a gear transmission rod. In order that two carrying arms B2 of the telescopic carrying assembly can be extended or retracted synchronously, one motor is employed to drive the two carrying arms B2. As shown in Figure 13, the driving rod connected to the motor and arranged transversely is driven by the motor to rotate. Each of two ends of the driving rod is provided with one first helical gear, and each of the two first helical gears is engaged with a second helical gear at the bottom end of the transmission rod corresponded to the first helical gear and arranged vertically, so as to drive the transmission rod to rotate. While the gear arranged at the top end of the transmission rod is engaged with the transmission gear B232 so as to achieve the driving effect.

For increasing the slide stability of the housing B21 and the supporting frame B3, a fixed slider B24 is provided at the top end of the supporting frame B3. The fixed slider B24 is cooperated with the slide rail B25 arranged at the lower end of the housing B21 and slides therein.

As shown in Figure 12 and Figure 14, for improving the sliding of the clamping assembly B1 with respect to the housing B21, the clamping assembly B1 is provided with a guide slider B13, and the housing B21 is provided with a guide rail B26 cooperated with the guide slider B 13.

Preferably, the clamping assembly further includes two pulleys which are provided at two ends of the housing B21 and are cooperated and in contact with the pulling rope B22. In order that the clamping assembly B1 is extended or retracted with respect to the housing B21 more smoothly, each of the two ends of the housing B21 is fixedly connected with a first pulley B27 with a small diameter and a second pulley B28 with a large diameter. The first pulley B27 is arranged at a front end of the housing B21 adjacent to the clamping assembly B1, and the second pulley B28 is arranged at the other end of the housing B21. With such an arrangement, the pulling rope B22 is arranged obliquely between the first pulley B27 and the second pulley B28, which facilitates the extending of the clamping assembly B1 with respect to the housing B21, thereby the picking operation can be performed quickly.

As shown in Figure 14, the clamping assembly B1 includes: a box-clamping seat B11 provided on the carrying arm B2, and two clamping units B12 provided in the box-clamping seat B11 for clamping the front surface and the back surface of the electricity meter turnover box, respectively. Since the front surface and the back surface of the electricity meter turnover box are clamped by the two clamping units B12, the electricity meter turnover box is clamped with an increased degree of freedom, which facilitates the performing of the clamping process.

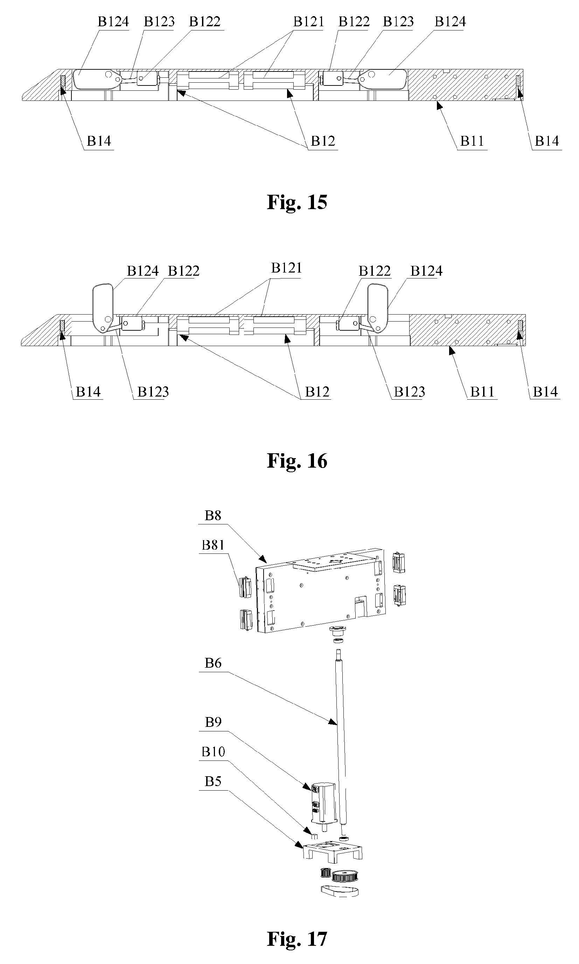

Referring to Figure 15 and Figure 16, Figure 15 is a sectional view of the clamping unit according to an embodiment of the present application, with the clamping unit being retracted; and Figure 16 is a sectional view of the clamping unit according to the embodiment of the present application, with the clamping unit being in operation.

For further facilitating the clamping process, the clamping unit B12 according to the embodiment of the present application includes: an independent first driving device B121 arranged in the box-clamping seat B11; a slider B122 arranged in the box-clamping seat B11 and driven by the first driving device B121 to slide along the inside of the box-clamping seat B11; and an articulated rod B123, one end of the articulated rod is articulated with the slider B122, and the other end of the articulated rod is articulated with a clamping claw B124 configured for abutting against the electricity meter turnover box. The box-clamping seat B11 is formed with a receiving groove for receiving the clamping claw B124. The slider B122 slides along the inside of the box-clamping seat B11 under the driving of the first driving device B121. Since the slider B122 is articulated with one end of the articulated rod B123, and the other end of the articulated rod B123 is articulated with the clamping claw B124, the articulated rod B123 is driven to move under the sliding of the slider B122, the connecting end of the clamping claw B124 connected with the articulated rod B123 is moved. Since a receiving groove for receiving the clamping claw B124 is formed on the box-clamping seat B11, when the connecting end of the clamping claw B124 which is connected with the articulated rod B123 is moved, since the clamping claw B124 is blocked by the end wall of the receiving groove from moving in the sliding direction of the slider B122, the free end of the clamping claw B124 is protruded out of the receiving groove and is abutted against the electricity meter turnover box, thereby finishing the clamping of the electricity meter turnover box. When the slider B122 is driven by the first driving device B121 to slide in the opposite direction, the clamping claw B124 is retracted into the receiving groove of the box-clamping seat B11 under the action of the articulated rod B123, thereby finishing the placing of the electricity meter turnover box.

In the above embodiments, preferably, the first driving device B121 is a cylinder.

The telescopic clamping unit according to the embodiment of the present application further includes: a first detection sensor B14 arranged on the clamping assembly B1 for detecting the position of the electricity meter turnover box. Since the position at which the electricity meter turnover box is mounted has been recorded by the electricity meter verification device, by means of the first detection sensor B 14, the detected information is compared with the recorded value to detect whether there is an electricity meter turnover box, so as to determine whether to perform the clamping. Thus the operating time is saved, and the operating time wasted for unnecessary operations in the picking and placing process is avoided.

As shown in Figure 13, the supporting frame B3 is further provided with a second detection sensor B32 for detecting the vertical position of the electricity meter turnover box. Since the position at which the electricity meter turnover box is placed on the electricity meter verification device has been recorded by the electricity meter verification device, by means of the second detection sensor B32, the detected information is compared with the recorded value to determine the state of the placing of the electricity meter turnover box on the electricity meter verification device, so as to increase the operation accuracy of the clamping process.

In order to be fully retracted to a zero position, the telescopic clamping unit may further include a third detection sensor B4 arranged at the top end of the supporting frame B3 for detecting the degree that the telescopic clamping unit is extended or retracted. When the telescopic clamping unit is fully retracted to the zero position, a zero position signal is sent so as to ensure the fully retraction of the telescopic clamping unit.

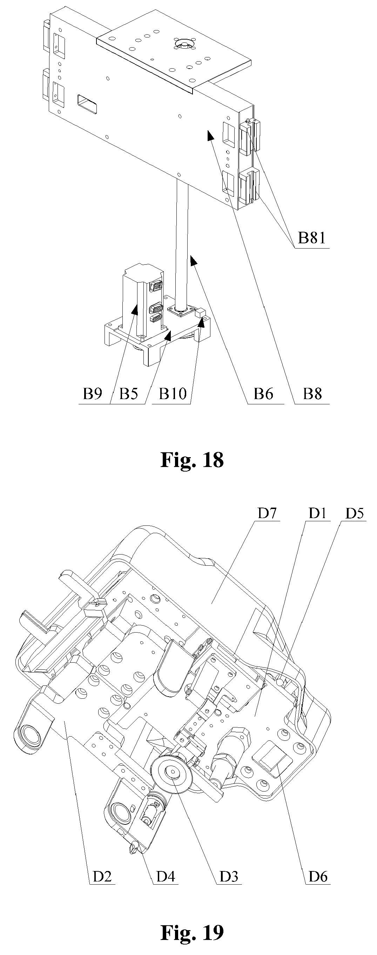

Referring to Figure 17 and Figure 18, Figure 17 is an exploded view of a lift unit according to an embodiment of the present application; and Figure 18 is a structural schematic view of the lift unit according to the embodiment of the present application.

As shown in Figure 17 and Figure 18, the lift unit includes: a support B5; a screw rod B6 arranged on the support B5, and a lift nut B7 is arranged on the telescopic clamping unit for cooperating with the screw rod B6 through threads; a fixing base B8 arranged at the top end of the screw rod B6 for fixedly connecting the chassis A, and the fixing base B8 is slidably cooperated with the telescopic clamping unit in the extending direction of the screw rod B6; and a driving component B9 arranged on the support B5 for driving the screw rod B6 to rotate. Since the fixing base B8 is slidably cooperated with the telescopic clamping unit along the extending direction of the screw rod B6, and the fixing base B8 is fixedly connected with the chassis A, the rotation of the telescopic clamping unit is effectively avoided, such that the telescopic clamping unit can only be moved up and down along the extending direction of the screw rod B6. After the driving component B9 is actuated, the screw rod B6 is rotated, and the lift nut B7 cooperated with the screw rod B6 through threads is moved up and down, thereby driving the telescopic clamping unit to move up and down along the screw rod B6.

Alternatively, an electric lift rod may be employed as the lift unit, and the telescopic clamping unit is fixed at the top end of the electric lift rod, such that the telescopic clamping unit is driven to move up and down under the extending and retracting actions of an inner rod and an outer rod of the electric lift rod.

The lift unit in the electricity meter verification robot according to an embodiment of the present application is arranged inside the chassis A, and the telescopic clamping unit is driven to move up and down under the vertical movement of the lift unit, thereby the electric energy verification robot has a compact structure, which further reduces the volume of the electric energy verification robot, thus the flexibility thereof is improved.

As shown in Figure 17, the driving component B9 is a motor, an output end thereof is provided with a driving pinion, and a driving wheel engaged with the driving pinion is coaxially arranged at a lower end of the screw rod B6. When the motor is actuated, the driving pinion is driven to rotate, and the driving wheel engaged with the driving pinion is driven to rotate, thereby the screw rod B6 is driven to rotate.

In order that the telescopic clamping unit is lifted or lowered more smoothly, a lift slider B81 is fixed on the fixing base B8, and the telescopic clamping unit is provided with a lift slideway B31 cooperated with the lift slider B81. In the present embodiment, the lift slideway B31 is arranged at the inner side of the supporting arm of the supporting frame B3.

In order that the lift unit can be retracted to the zero position accurately after the clamping operation, a fourth detection sensor B10 is provided at the top end of the support B5 for detecting the distance between the telescopic clamping unit and the top end of the support B5. After the telescopic clamping unit is lowered to the zero position, the fourth detection sensor B10 sends a zero position signal to ensure that the lift unit is completely retracted.

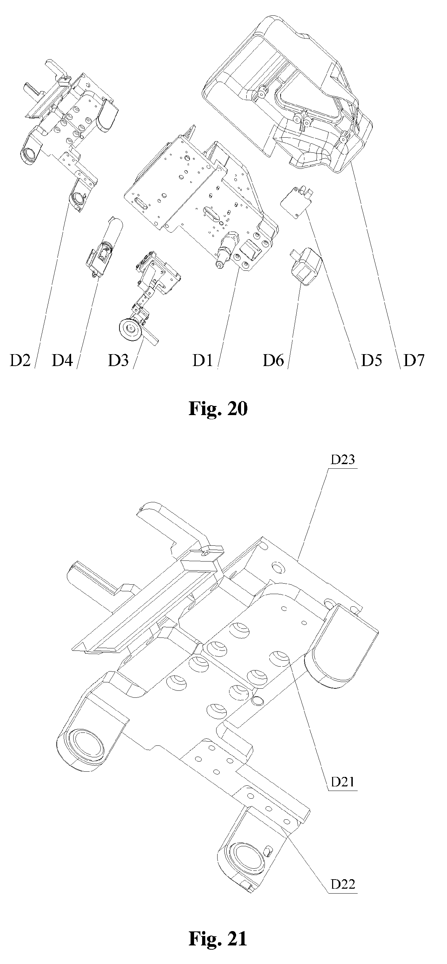

Referring to Figure 19 and Figure 20, Figure 19 is a structural schematic view of a mechanical hand according to an embodiment of the present application, and Figure 20 is an exploded view of the mechanical hand according to the embodiment of the present application.

The mechanical hand D according to the embodiment of the present application includes: a base D1; an integrated claw D2 arranged on the base D1 for clamping the IC card and the electricity meter; a cover-turning device D3 arranged on the base D1 for opening or closing an electricity meter programming cover; and a screwing device D4 arranged on the base D1 for screwing a screw and pressing a programming button.

In the mechanical hand D according to the embodiment of the present application, the integrated claw D2 for clamping the IC card and the electricity meter, the cover-turning device D3 for opening or closing the electricity meter programming cover, and the screwing device D4 for screwing the screw and pressing the programming button are arranged on the base D1, thereby the mechanical hand D can perform the picking of the electricity meter and the IC card, the turning of the electricity meter programming cover, and the pressing of the programming button arranged behind the electricity meter programming cover, which is convenient to set the data of the electricity meter, effectively avoids the complicated manual operation, greatly saves the time required for manual operation, and improves the working efficiency.

As shown in Figure 21, the integrated claw D2 according to the embodiment of the present application includes: a first clamping finger D21 and a second clamping finger D22 for clamping two sides of the electricity meter and the IC card, respectively; and a second driving device D23 fixedly connected to the base D1 for driving the first clamping finger D21 and the second clamping finger D22 to perform clamping motions. It is to be noted that, by the above clamping motions, i.e., the first clamping finger D21 and the second clamping finger D22 are moved towards each other or away from each other, the IC card and the electricity meter are picked or released.

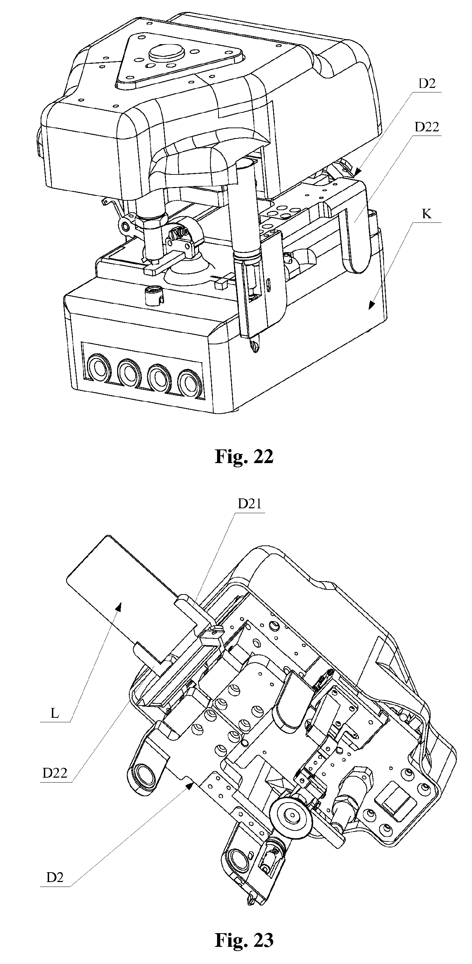

Referring to Figure 22 and Figure 23, Figure 22 is an operational schematic view showing that the mechanical hand according to an embodiment of the present application is picking an electricity meter; and Figure 23 is an operational schematic view showing that the mechanical hand according to the embodiment of the present application is picking an IC card.

One end of the first clamping finger D21 according to the embodiment of the present application is provided with a first IC card-clamping end, and the other end of the first clamping finger D21 is provided with a first electricity meter-clamping end. One end of the second clamping finger D22 is provided with a second IC card-clamping end for cooperating with the first IC card-clamping end to clamp the IC card L, and the other end of the second clamping finger D22 is provided with a second electricity meter-clamping end for cooperating with the first electricity meter-clamping end to clamp the electricity meter K. In the process of picking and placing the electricity meter K, the first clamping finger D21 and the second clamping finger D22 are moved towards each other, such that the electricity meter K is clamped by the first electricity meter-clamping end of the first clamping finger D21 and the second electricity meter-clamping end of the second clamping finger D22 and is taken out of the electricity meter turnover box, and then the electricity meter K is placed at the predetermined position. Then the first clamping figure D21 and the second clamping finger D22 are moved away from each other such that the electricity meter K is released by the first electricity meter-clamping end and the second electricity meter-clamping end, thereby the electricity meter K can be verified. In the process of picking and placing the IC card L, similarly, the first clamping finger D21 and the second clamping finger D22 are moved towards each other such that the IC card L is clamped by the first IC card-clamping end of the first clamping finger D21 and the second IC card-clamping end of the second clamping finger D22 and is taken out of the receiving box for the IC card, then the IC card can be inserted into the electricity meter K and thus the electricity meter K can be verified. After then, the IC card L is placed back into the IC card box, and the first clamping figure D21 and the second clamping finger D22 are moved away from each other, such that the IC card L is released from the first IC card-clamping end and the second IC card-clamping end.

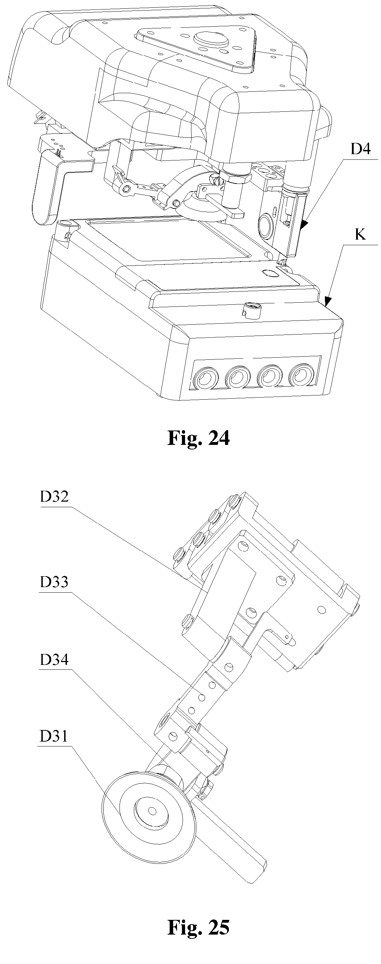

Referring to Figure 24 which is an operational schematic view showing that the mechanical hand according to the embodiment of the present application is screwing a screw.

The screwing device D4 includes: a screwdriver matched with a screw on the electricity meter programming cover, and a driving element fixedly provided on the base D1 for driving the screwdriver to rotate. In the screwing operation of the mechanical hand, the mechanical hand is moved to be adjacent to the electricity meter such that the screwdriver is cooperated and in contact with the screw on the programming cover D1 of the electricity meter; and then the screwdriver is driven by the driving element to rotate such that the screw is tightened or loosened. Alternatively, the screwdriver may be rotated manually.

Preferably, a motor is employed as the driving element in the embodiment of the present application.

Since in the process of screwing the screw by the screwdriver, the connecting end of the screwdriver with the driving element is distanced from the screwing end thereof, the screwdriver may be shaken during the screwing operation, which may lower the screwing effect. For relieving the shaking of the screwdriver, the screwing device D4 may further includes a supporting component connected to the integrated claw D2 in a snap fit manner for supporting the screwdriver. The supporting component is preferably connected to the second electricity meter-clamping end of the integrated claw 2 in the snap fit manner.

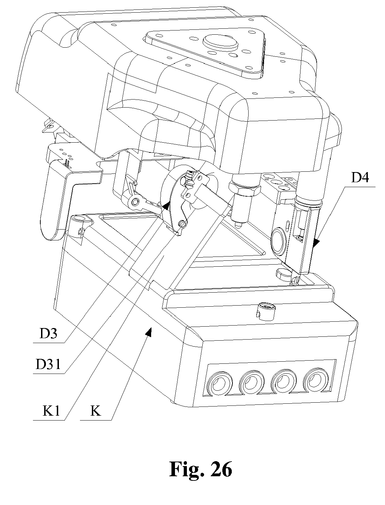

Referring to Figure 25 and Figure 26, Figure 25 is a structural schematic view of a cover-turning device according to an embodiment of the present application; and Figure 26 is an operational schematic view showing that the mechanical hand according to the embodiment of the present application is turning the cover and pressing a programming button.

The cover-turning device D3 includes: a sucking disk D31 for sucking the electricity meter programming cover K1; a fixing arm D32 connected to the base D1; a rotating arm D33, one end of the rotating arm is articulated with the fixing arm D32, and the other end of the rotating arm D33 is connected to the sucking disk D31, preferably, by a pin. When it requires to open the electricity meter programming cover K1, the mechanical hand is moved to be adjacent to the electricity meter K, and the rotating arm D33 is controlled to rotate with respect to the fixing arm D32, such that the sucking disk D31 connected to the rotating arm D33 is abutted on the electricity meter programming cover K1 and both components are pressed by each other. Since the air in the space formed by the sucking disk D31 and the electricity meter programming cover K1 is reduced when the sucking disk D31 is pressed, the sucking disk D31 is sucked on the electricity meter programming cover K1. Then the rotating arm D33 is rotated with respect to the fixing arm D32, driving the sucking disk D31 to be away from the electricity meter K, thereby turning the electricity meter programming cover K1 such that it is opened.

Since the air in the space formed by the sucking disk and the electricity meter programming cover is reduced when the sucking disk D31 is pressed, the sucking disk D31 is sucked on the electricity meter programming cover K1. That is, the edge of the sucking disk D31 should be abutted on the electricity meter programming cover K1 to avoid the circumstance in which the air outside enters the sucking disk D31 via the edge of the sucking disk D31 causing the sucking force between the sucking disk D31 and the electricity meter programming cover K1 to disappear. For adjusting the angle at which the edge of the sucking disk D31 is in contact with the electricity meter programming cover K1, so as to decrease the possibility that the edge of the sucking disk is separated from the electricity meter programming cover K1 due to a gap between the edge of the sucking disk and the electricity meter programming cover K1, the cover-turning device D3 may further includes a connecting arm D34 articulated with the rotating arm D33, and the sucking disk D31 is arranged at one end of the connecting arm D34 away from the rotating arm D33. By rotating the connecting arm D34 with respect to the rotating arm D33, the sucking disk D31 may be further adjusted such that the edge thereof is in contact the electricity meter programming cover K1 in a relatively parallel manner, so as to reduce the gap between the edge of the sucking disk D31 and the electricity meter programming cover K1 when they are contacted with each other, which can help the sucking disk D31 to suck the electricity meter programming cover K1 in a better way.

As shown in Figure 26, for further shortening the operation time, at the time that the electricity meter programming cover K1 is turned by the mechanical hand according to the embodiment of the present application, that is, at the time that the electricity meter programming cover K1 is sucked by the sucking disk D31, the screwdriver of the screwing device is driven to press the programming button at the portion of the electricity meter covered by the electricity meter programming cover K1, so as to shorten the operation time, and further improve the working efficiency.

As shown in Figure 19 and Figure 20, the mechanical hand according to the embodiment of the present application may further includes: an infrared communication device D5 arranged on the base D1, and a video capture device D6 arranged on the base D1. The infrared communication device D5 is configured for detecting the infrared communication performance of the electricity meter, and the video capture device D6 is configured for capturing information of the electricity meter such as the screen, the nameplate, the indicator lamp, and the profile of the electricity meter, or other image information.

In the present embodiment, the mechanical hand further includes a protection cover D7 arranged on the base D1, and the protection cover D7 is provided with a connecting end for connecting the mechanical arm C.

The mechanical arm C according to an embodiment of the present application includes: a first connecting end rotatably connected to the chassis A; a first connecting arm, one end of which is articulated with the first connecting end; a second connecting end articulated with the other end of the first connecting arm; a second connecting arm rotatably connected to the second connecting end; and a third connecting end articulated with the second connecting arm, and the third connecting end is rotatably connected to the mechanical hand D. With such an arrangement, the mechanical arm C can be adjusted at an angle of 360 degree in the horizontal and vertical planes, so as to avoid the occurrence of a dead angle in controlling the mechanical hand D to move. Thus the flexibility of the electricity meter verification robot according to the embodiment of the present application is improved effectively.

For facilitating the moving of the chassis A, the electricity meter verification robot may further includes a rail F slidably cooperated with the chassis A such that the chassis A is moved in a predetermined direction. A rolling wheel may be provided at the bottom portion of the chassis A, and the chassis A is pushed manually or controlled by the control cabinet E to move.

It is further provided according to an embodiment of the present application an electricity meter verification system including: an electricity meter verification platform having an electricity meter verification station, and any one of the electricity meter verification robots described above. The electricity meter verification robot is cooperated with the electricity meter verification platform. With the electricity meter verification robots as described above, the electricity meter verification system has the same technical effects as those of the above electricity meter verification robots, which will not be introduced in detail.

The embodiments are described herein in a progressive manner. Description of each of the embodiments is mainly focused on differences between the embodiment and the other embodiments, and references may be made among these embodiments with respect to the same or similar components.

Those skilled in the art can achieve or implement the present application based on the above description of the embodiments, and it is apparent that those skilled in the art may make multiple modifications to the embodiments. The general principle defined herein can be implemented in other embodiments without departing from the scope of the appended claims.

## Claims

1. An electricity meter verification robot, comprising:
a chassis (A);
an electricity meter turnover box-picking and placing mechanism (B) provided on the chassis (A) for picking and placing an electricity meter turnover box;
a mechanical hand (D) for picking, placing and verifying an electricity meter; and
a mechanical arm (C) provided on the chassis (A) for controlling a position of the mechanical hand (D), wherein the mechanical hand (D) is arranged at an end of the mechanical arm (C) away from the chassis (A),
wherein the electricity meter turnover box-picking and placing mechanism (B) comprises:
a telescopic clamping unit for clamping the electricity meter turnover box; and
a lift unit connected to the telescopic clamping unit for lifting or lowering the telescopic clamping unit.

2. The electricity meter verification robot according to claim 1, further comprising a control cabinet (E) which is in communication connection with the chassis (A), the electricity meter turnover box-picking and placing mechanism (B), the mechanical hand (D) and the mechanical arm (C), and the control cabinet (E) comprises a control component for sending a control signal and an energy supply device for supplying electric energy, wherein the control component is connected to the chassis (A), the electricity meter turnover box-picking and placing mechanism (B), the mechanical hand (D) and the mechanical arm (C) via cables or is in wireless communication connection with the chassis (A), the electricity meter turnover box-picking and placing mechanism (B), the mechanical hand (D) and the mechanical arm (C); and the energy supply device is connected to the chassis (A), the electricity meter turnover box-picking and placing mechanism (B), the mechanical hand (D) and the mechanical arm (C) via cables.

3. The electricity meter verification robot according to claim 1, wherein the telescopic clamping unit comprises:
two clamping assemblies (B1) for clamping two sides of the electricity meter turnover box, with clamping directions of the two clamping assemblies (B1) being arranged opposite to each other; and
a telescopic carrying assembly connected to the lift unit for driving the clamping assemblies (B1) to extend or retract.

4. The electricity meter verification robot according to claim 3, wherein the telescopic carrying assembly comprises two carrying arms (B2) and a supporting frame (B3) fixedly connected to ends of the two carrying arms (B2) located on the same side; and the two clamping assemblies (B1) are provided on the two carrying arms (B2), respectively and are slideable on the two carrying arms synchronously.

5. The electricity meter verification robot according to claim 4, wherein the carrying arm (B2) comprises:
a housing (B21) slidably cooperated with the clamping assembly (B1), and the housing (B21) is slidably connected to the supporting frame (B3);
a pulling rope (B22) for pulling the clamping assembly (B1) to slide with respect to the housing (B21), with two ends of the pulling rope (B22) being fixedly connected with the supporting frame (B3); and
a driving unit (B23) for driving the housing (B21) to slide with respect to the supporting frame (B3).

6. The electricity meter verification robot according to claim 5, wherein the driving unit (B23) comprises:
a rack (B231) provided on the housing (B21);
a transmission gear (B232) provided on the supporting frame (B3) and engaged with the rack (B231); and
a first slide driving device (B233) for driving the transmission gear (B232) to rotate.

7. The electricity meter verification robot according to claim 4, wherein the clamping assembly (B1) comprises:
a box-clamping seat (B11) provided on the carrying arm (B2); and
two clamping units (B12) provided in the box-clamping seat (B11) for clamping a front surface and a back surface of the electricity meter turnover box, respectively.

8. The electricity meter verification robot according to claim 7, wherein the clamping unit (B12) comprises:
a first driving device (B121) provided in the box-clamping seat (B11);
a slider (B122) provided in the box-clamping seat (B11) and driven by the first driving device (B121) to slide along an inside of the box-clamping seat (B11); and
an articulated rod (B123), one end of the articulated rod is articulated with the slider (B122), and the other end of the articulated rod (B123) is articulated with a clamping claw (B 124) which is configured for abutting against the electricity meter turnover box, and the box-clamping seat (B11) is formed with a receiving groove for receiving the clamping claw (B124).

9. The electricity meter verification robot according to claim 1, wherein the lift unit comprises:
a support (B5);
a screw rod (B6) provided on the support (B5), and a lift nut (B7) is provided on the telescopic clamping unit for cooperating with the screw rod (B6) through threads;
a fixing base (B8) provided at a top end of the screw rod (B6) for fixedly connecting the chassis (A), and the fixing base (B8) is slidably cooperated with the telescopic clamping unit along an extending direction of the screw rod (B6); and
a driving component (B9) provided on the support (B5) for driving the screw rod (B6) to rotate.

10. The electricity meter verification robot according to claim 1, wherein the mechanical hand comprises:
a base (D1);
an integrated claw (D2) provided on the base (D1) for clamping an IC card and the electricity meter;
a cover-turning device (D3) provided on the base (D1) for opening or closing an electricity meter programming cover; and
a screwing device (D4) provided on the base (D1) for screwing a screw and pressing a programming button.

11. The electricity meter verification robot according to claim 10, wherein the integrated claw (D2) comprises:
a first clamping finger (D21) and a second clamping finger (D22) for clamping two sides of the electricity meter and the IC card, respectively; and
a second driving device (D23) fixedly connected to the base (D1) for driving the first clamping finger (D21) and the second clamping finger (D22) to perform clamping motions.

12. The electricity meter verification robot according to claim 11, wherein one end of the first clamping finger (D21) is provided with a first IC card-clamping end, and the other end of the first clamping finger is provided with a first electricity meter-clamping end; and
one end of the second clamping finger (D22) is provided with a second IC card-clamping end for cooperating with the first IC card-clamping end to clamp the IC card, and the other end of the second clamping finger is provided with a second electricity meter-clamping end for cooperating with the first electricity meter-clamping end to clamp the electricity meter.

13. The electricity meter verification robot according to claim 12, wherein the screwing device (D4) comprises:
a screwdriver matched with a screw on the electricity meter programming cover;
a driving element fixedly provided on the base (D1) for driving the screwdriver to rotate; and
a supporting component connected to the integrated claw (D2) in a snap fit manner for supporting the screwdriver.

14. The electricity meter verification robot according to claim 10, wherein the cover-turning device (D3) comprises:
a sucking disk (D31) for sucking the electricity meter programming cover;
a fixing arm (D32) connected to the base (D1);
a rotating arm (D33), one end of which is articulated with the fixing arm (D32); and
a connecting arm (D34) articulated with the other end of the rotating arm (D33), and the sucking disk (D31) is fixedly provided at one end of the connecting arm (D34) away from the rotating arm (D33).

15. The electricity meter verification robot according to claim 10, wherein the mechanical hand further comprises:
an infrared communication device (D5) provided on the base (D1) for verifying the infrared communication performance of the electricity meter; and
a video capture device (D6) provided on the base (D1) for capturing information of the electricity meter.

16. The electricity meter verification robot according to any one of claims 10 to 15, wherein the mechanical hand further comprises a protection cover (D7) provided on the base (D1), and the protection cover (D7) is provided with a connecting end for connecting the mechanical arm (C).

17. The electricity meter verification robot according to claim 1, wherein the mechanical arm (C) comprises:
a first connecting end rotatably connected to the chassis (A);
a first connecting arm, one end of which is articulated with the first connecting end;
a second connecting end articulated with the other end of the first connecting arm;
a second connecting arm rotatably connected to the second connecting end; and
a third connecting end articulated with the second connecting arm, and the third connecting end is rotatably connected to the mechanical hand (D).

18. An electricity meter verification system, comprising an electricity meter verification platform having an electricity meter verification station, wherein the electricity meter verification system further comprises an electricity meter verification robot according to any one of claims 1 to 17, and the electricity meter verification robot is cooperated with the electricity meter verification platform.

## Patentansprüche

1. Stromzählerüberprüfungsautomat, der Folgendes umfasst:
ein Gehäuse (A);
einen Mechanismus (B) zum Aufnehmen und Platzieren eines Stromzählerumsetzungskastens, der auf dem Gehäuse (A) vorgesehen ist, um einen Stromzählerumsetzungskasten aufzunehmen und zu platzieren;
eine mechanische Hand (D) zum Aufnehmen, Platzieren und Überprüfen eines Stromzählers; und
einen mechanischen Arm (C), der auf dem Gehäuse (A) vorgesehen ist, um eine Position der mechanischen Hand (D) zu steuern, wobei die mechanische Hand (D) an einem Ende des mechanischen Arms (C) entfernt von dem Gehäuse (A) vorgesehen ist,
wobei der Mechanismus (B) zum Aufnehmen und Platzieren eines Stromzählerumsetzungskastens Folgendes umfasst:
eine ausziehbare Klemmeinheit zum Einklemmen des Stromzählerumsetzungskastens; und
eine Hebeeinheit, die mit der ausziehbaren Klemmeinheit verbunden ist, um die ausziehbare Klemmeinheit zu heben oder zu senken.

2. Stromzählerüberprüfungsautomat nach Anspruch 1, der ferner einen Kontrollschrank (E) umfasst, der in einer Kommunikationsverbindung mit dem Gehäuse (A) ist, wobei der Mechanismus (B) zum Aufnehmen und Platzieren eines Stromzählerumsetzungskastens, die mechanische Hand (D) und der mechanische Arm (C) und der Kontrollschrank (E) eine Steuerkomponente, um ein Steuersignal zu senden, und eine Energieversorgungsvorrichtung, um elektrische Energie zu liefern, umfassen, wobei die Steuerkomponente mit dem Gehäuse (A), dem Mechanismus (B) zum Aufnehmen und Platzieren eines Stromzählerumsetzungskastens, der mechanischen Hand (D) und dem mechanischen Arm (C) über Kabel verbunden ist oder in einer drahtlosen Kommunikationsverbindung mit dem Gehäuse (A), dem Mechanismus (B) zum Aufnehmen und Platzieren eines Stromzählerumsetzungskastens, der mechanischen Hand (D) und dem mechanischen Arm (C) ist; und die Energieversorgungsvorrichtung mit dem Gehäuse (A), dem Mechanismus (B) zum Aufnehmen und Platzieren eines Stromzählerumsetzungskastens, der mechanischen Hand (D) und dem mechanischen Arm (C) über Kabel verbunden ist.

3. Stromzählerüberprüfungsautomat nach Anspruch 1, wobei die ausziehbare Klemmeinheit Folgendes umfasst:
zwei Klemmanordnungen (B1), um zwei Seiten des Stromzählerumsetzungskastens einzuklemmen, wobei die Klemmrichtungen der beiden Klemmanordnungen (B1) einander gegenüberliegend angeordnet sind; und
eine ausziehbare Trageanordnung, die mit der Hebeeinheit verbunden ist, um die Klemmanordnungen (B1) so anzutreiben, dass sie ausgefahren oder eingezogen werden.

4. Stromzählerüberprüfungsautomat nach Anspruch 3, wobei die ausziehbare Trageanordnung zwei Tragarme (B2) und einen Tragrahmen (B3), der fest an den Enden der beiden Tragarme (B2), die sich auf derselben Seite befinden, befestigt ist, umfasst; und die beiden Klemmanordnungen (B1) jeweils auf den beiden Tragarmen (B2) vorgesehen sind und auf den beiden Tragarmen gleichzeitig gleiten können.

5. Stromzählerüberprüfungsautomat nach Anspruch 4, wobei der Tragarm (B2) Folgendes umfasst:
ein Gehäuse (B21), das mit der Klemmanordnung (B1) gleitend zusammenwirken kann, wobei das Gehäuse (B21) mit dem Tragrahmen (B3) gleitfähig verbunden ist;
ein Zugseil (B22) zum Ziehen der Klemmanordnung (B1), so dass sie in Bezug auf das Gehäuse (B21) gleitet, wobei zwei Enden des Zugseils (B22) mit dem Tragrahmen (B3) fest verbunden sind; und
eine Antriebseinheit (B23), um das Gehäuse (B21) so anzutreiben, dass es in Bezug auf den Tragrahmen (B3) gleitet.

6. Stromzählerüberprüfungsautomat nach Anspruch 5, wobei die Antriebseinheit (B23) Folgendes umfasst:
ein Gestell (B231), das auf dem Gehäuse (B21) vorgesehen ist;
ein Getriebe (B232), das auf dem Tragrahmen (B3) vorgesehen ist und mit dem Gestell (B231) in Eingriff ist; und
eine erste Gleitantriebsvorrichtung (B233), um das Getriebe (B232) so anzutreiben, dass es sich dreht.

7. Stromzählerüberprüfungsautomat nach Anspruch 4, wobei die Klemmanordnung (B1) Folgendes umfasst:
einen Kastenklemmsitz (B11), der auf dem Tragarm (B2) vorgesehen ist; und
zwei Klemmeinheiten (B12), die in dem Kastenklemmsitz (B11) vorgesehen sind, um jeweils eine Vorderfläche und eine Rückfläche des Stromzählerumsetzungskastens einzuklemmen.

8. Stromzählerüberprüfungsautomat nach Anspruch 7, wobei die Klemmeinheit (B12) Folgendes umfasst:
eine erste Antriebsvorrichtung (B121), die in dem Kastenklemmsitz (B11) vorgesehen ist;
ein Gleitelement (B122), das in dem Kastenklemmsitz (B11) vorgesehen ist und durch die erste Antriebsvorrichtung (B121) so angetrieben wird, dass es entlang einem Inneren des Kastenklemmsitzes (B11) gleitet; und
einen Gelenkstab (B123), wobei ein Ende des Gelenkstabs mit dem Gleitelement (B122) gelenkig gelagert ist und das andere Ende des Gelenkstabs (B123) mit einer Spannklaue (B124) gelenkig gelagert ist, die so konfiguriert ist, dass sie an dem Stromzählerumsetzungskasten anstößt, und der Kastenklemmsitz (B11) mit einer Aufnahmekerbe zum Aufnehmen der Spannklaue (B124) gebildet ist.

9. Stromzählerüberprüfungsautomat nach Anspruch 1, wobei die Hebeeinheit Folgendes umfasst:
ein Tragelement (B5);
einen Schraubstab (B6), der an dem Tragelement (B5) vorgesehen ist, wobei eine Hebemutter (B7) an der ausziehbaren Klemmeinheit vorgesehen ist, um mit dem Schraubstab (B6) durch Gewinde zusammenzuwirken;
eine Fixierbasis (B8), die an einem oberen Ende des Schraubstabs (B6) vorgesehen ist, um das Gehäuse (A) fest zu verbinden, und wobei die Fixierbasis (B8) mit der ausziehbaren Klemmeinheit entlang einer Erstreckungsrichtung des Schraubstabs (B6) gleitend zusammenwirkt; und
eine Antriebskomponente (B9) die auf dem Tragelement (B5) vorgesehen ist, um den Schraubstab (B6) so anzutreiben, dass er sich dreht.

10. Stromzählerüberprüfungsautomat nach Anspruch 1, wobei die mechanische Hand Folgendes umfasst:
eine Basis (D1);
eine integrierte Klaue (D2), die auf der Basis (D1) vorgesehen ist, um eine IC-Karte und den Stromzähler einzuklemmen;
eine Abdeckungsumdrehvorrichtung (D3), die auf der Basis (D1) vorgesehen ist, um eine Stromzählerprogrammierabdeckung zu öffnen oder zu schließen; und
eine Schraubvorrichtung (D4), die an der Basis (D1) vorgesehen ist, um eine Schraube zu schrauben und einen Programmierknopf zu drücken.

11. Stromzählerüberprüfungsautomat nach Anspruch 10, wobei die integrierte Klaue (D2) Folgendes umfasst:
einen ersten Klemmfinger (D21) und einen zweiten Klemmfinger (D22) zum Einklemmen von jeweils zwei Seiten des Stromzählers und der IC-Karte; und
eine zweite Antriebsvorrichtung (D23), die mit der Basis (D1) fest verbunden ist, um den ersten Klemmfinger (D21) und den zweiten Klemmfinger (D22) so anzutreiben, dass sie Klemmbewegungen ausführen.

12. Stromzählerüberprüfungsautomat nach Anspruch 11, wobei ein Ende des ersten Klemmfingers (D21) mit einem ersten IC-Kartenklemmende ausgestattet ist und das andere Ende des ersten Klemmfingers mit einem ersten Stromzählerklemmende ausgestattet ist; und
ein Ende des zweiten Klemmfingers (D22) mit einem zweiten IC-Kartenklemmende ausgestattet ist, um mit dem ersten IC-Kartenklemmende der IC-Karte zusammenzuwirken, und das andere Ende des zweiten Klemmfingers mit einem zweiten Stromzählerklemmende ausgestattet ist, um mit dem ersten Stromzählerklemmende zusammenzuarbeiten, um den Stromzähler einzuklemmen.

13. Stromzählerüberprüfungsautomat nach Anspruch 12, wobei die Schraubvorrichtung (D4) Folgendes umfasst:
einen Schraubenzieher, der mit einer Schraube auf der Stromzählerprogrammierabdeckung zusammenpasst;
ein Antriebselement, das fest auf der Basis (D1) vorgesehen ist, um den Schraubenzieher so anzutreiben, dass er sich dreht; und
eine Tragkomponente, die mit der integrierten Klaue (D2) in einer Schnappverschlussweise verbunden ist, um den Schraubenzieher zu tragen.

14. Stromzählerüberprüfungsautomat nach Anspruch 10, wobei die Abdeckungsumdrehvorrichtung (D3) Folgendes umfasst:
eine Saugscheibe (D31), um die Stromzählerprogrammierabdeckung anzusaugen;
einen Fixierarm (D32), der mit der Basis (D1) verbunden ist;
einen Dreharm (D33), wovon ein Ende mit dem Fixierarm (D32) gelenkig gelagert ist; und
einen Verbindungsarm (D34), der mit dem anderen Ende des Dreharms (D33) gelenkig gelagert ist, wobei die Saugscheibe (D31) an einem Ende des Verbindungsarms (D34) entfernt von dem Dreharm (D33) fest vorgesehen ist.

15. Stromzählerüberprüfungsautomat nach Anspruch 10, wobei die mechanische Hand ferner Folgendes umfasst:
eine Infrarotkommunikationsvorrichtung (D5), die auf der Basis (D1) vorgesehen ist, um die Infrarotkommunikationsleistung des Stromzählers zu überprüfen; und
eine Videoaufnahmevorrichtung (D6), die auf der Basis (D1) vorgesehen ist, um Informationen des Stromzählers aufzunehmen.

16. Stromzählerüberprüfungsautomat nach einem der Ansprüche 10 bis 15, wobei die mechanische Hand ferner eine Schutzabdeckung (D7) umfasst, die auf der Basis (D1) vorgesehen ist, und wobei die Schutzabdeckung (D7) mit einem Verbindungsende ausgestattet ist, um den mechanischen Arm (C) zu verbinden.

17. Stromzählerüberprüfungsautomat nach Anspruch 1, wobei der mechanische Arm (C) Folgendes umfasst:
ein erstes Verbindungsende, das mit dem Gehäuse (A) drehbar verbunden ist;
einen ersten Verbindungsarm, wovon ein Ende mit dem ersten Verbindungsende gelenkig gelagert ist;
ein zweites Verbindungsende, das mit dem anderen Ende des ersten Verbindungsarms gelenkig gelagert ist;
einen zweiten Verbindungsarm, der mit dem zweiten Verbindungsende drehbar verbunden ist; und
ein drittes Verbindungsende, das mit dem zweiten Verbindungsarm gelenkig gelagert ist, und wobei das dritte Verbindungsende mit der mechanischen Hand (D) drehbar verbunden ist.

18. Stromzählerüberprüfungssystem, das eine Stromzählerüberprüfungsplattform mit einer Stromzählerüberprüfungsstation umfasst, wobei das Stromzählerüberprüfungssystem ferner einen Stromzählerüberprüfungsautomaten nach einem der Ansprüche 1 bis 17 umfasst und der Stromzählerüberprüfungsautomat mit der Stromzählerüberprüfungsplattform zusammen betrieben wird.

## Revendications

1. Robot de vérification de compteurs d'électricité comprenant :
un châssis (A),
un mécanisme de prélèvement et de placement d'un boîtier de déplacement de compteurs d'électricité (B) prévu sur le châssis (A) pour prélever et placer un boîtier de déplacement de compteur d'électricité,
une main mécanique (D) permettant de prélever, placer et vérifier un compteur d'électricité, et
un bras mécanique (C) prévu sur le châssis (A) pour commander la position de la main mécanique (D), la main mécanique (D) étant agencée à une extrémité du bras mécanique (C) à distance du châssis (A),
dans lequel le mécanisme de prélèvement et de placement d'un boîtier de déplacement de compteurs d'électricité (B) comprend :
une unité de serrage télescopique permettant de bloquer le boîtier de déplacement de compteur d'électricité, et
une unité de levage raccordée à l'unité de serrage télescopique pour lever ou abaisser l'unité de serrage télescopique.

2. Robot de vérification de compteurs d'électricité selon la revendication 1, comprenant en outre une armoire de commande (E) qui se trouve reliée par communication avec le châssis (A), le mécanisme de prélèvement et de placement d'un boîtier de déplacement de compteurs d'électricité (B), la main mécanique (D) et le bras mécanique (C), l'armoire de commande (E) comprenant un composant de commande permettant d'envoyer un signal de commande est un dispositif d'alimentation en énergie permettant de fournir de l'énergie électrique, le composant de commande étant relié au châssis (A), au mécanisme de prélèvement et de placement d'un boîtier de déplacement de compteurs d'électricité (B), à la main mécanique (D) et au bras mécanique (C) par l'intermédiaire de câbles, ou bien étant relié par communication sans fil au châssis (A), au mécanisme de prélèvement et de placement d'un boîtier de déplacement de compteurs d'électricité (B), à la main mécanique (D) et au bras mécanique (C) ; et le dispositif d'alimentation en énergie étant relié au châssis (A), au mécanisme de prélèvement et de placement d'un boîtier de déplacement de compteurs d'électricité (B), à la main mécanique (D) et au bras mécanique (C) par l'intermédiaire de câbles.

3. Robot de vérification de compteurs d'électricité selon la revendication 1, dans lequel l'unité de serrage télescopique comprend :
deux assemblages de serrage (B1) permettant de bloquer deux flancs du boîtier de déplacement de compteur d'électricité, les directions de serrage des deux assemblages de serrage (B1) étant agencées pour être opposées l'une à l'autre, et
un ensemble de transport télescopique raccordé à l'unité de levage pour entraîner les assemblages de serrage (B1) pour qu'ils s'étendent ou se rétractent.

4. Robot de vérification de compteurs d'électricité selon la revendication 3, dans lequel l'ensemble de transport télescopique comprend deux bras de transport (B2) et un cadre de support (B3) reliés de manière fixe à des extrémités des deux bras de transport (B2) situés sur le même côté ; et les deux assemblages de serrage (B1) sont respectivement prévus sur les deux bras de transport (B2) et peuvent coulisser de manière synchrone sur les deux bras de transport.

5. Robot de vérification de compteurs d'électricité selon la revendication 4, dans lequel le bras de transport (B2) comprend :
un logement (B21) coopérant par coulissement avec l'assemblage de serrage (B1) ; et le logement (B21) est raccordé en pouvant coulisser sur le cadre de support (B3),
un câble de traction (B22) permettant de tracter l'assemblage de serrage (B1) pour qu'il coulisse par rapport au logement (B21), deux extrémités du câble de traction (B22) étant reliées de manière fixe au cadre de support (B3), et
une unité d'entraînement (B23) permettant d'entraîner le logement (B21) pour qu'il coulisse par rapport au cadre de support (B3).

6. Robot de vérification de compteurs d'électricité selon la revendication 5, dans lequel l'unité d'entraînement (B23) comprend :
un bâti (B231) prévu sur le logement (B21),
un pignon de transmission (B232) prévu sur le cadre de support (B3) et en prise avec le bâti (B231), et
un premier dispositif d'entraînement à glissière (B233) permettant entraîner le pignon de transmission (B232) pour qu'il tourne.

7. Robot de vérification de compteurs d'électricité selon la revendication 4, dans lequel l'assemblage de serrage (B1) comprend :
un berceau de serrage de boîtier (B11) prévu sur le bras de transport (B2), et
deux unités de serrage (B12) prévues dans le berceau de serrage de boîtier (B11) pour bloquer respectivement la surface avant et la surface arrière du boîtier de déplacement de compteur d'électricité.

8. Robot de vérification de compteurs d'électricité selon la revendication 7, dans lequel l'unité de serrage (B12) comprend :
un premier dispositif d'entraînement (B121) prévu dans le berceau de serrage de boîtier (B11),
un coulisseau (B122) prévu dans le berceau de serrage de boîtier (B11) et entraîné par le premier dispositif d'entraînement (B121) pour coulisser le long de l'intérieur du berceau de serrage de boîtier (B11), et
une tige articulée (B123), une première extrémité de la tige articulée étant articulée avec le coulisseau (B122) et l'autre extrémité de la tige articulée (B123) étant articulée avec une griffe de serrage (B124) qui est configurée pour venir en butée contre le boîtier de déplacement de compteur d'électricité ; et le berceau de serrage de boîtier (B11) est muni d'une rainure de réception permettant de recevoir la griffe de serrage (B124).

9. Robot de vérification de compteurs d'électricité selon la revendication 1, dans lequel l'unité de levage comprend :
un support (B5),
une tige filetée (B6) prévue sur le support (B5) ; et un écrou de levage (B7) est prévu sur l'unité de serrage télescopique pour coopérer avec la tige filetée (B6) grâce au filetage,
une base de fixation (B8) prévue à l'extrémité supérieure de la tige filetée (B6) afin de se relier au châssis (A) de manière fixe, et la base de fixation (B8) coopère par coulissement avec l'unité de serrage télescopique le long de la direction d'extension de la tige filetée (B6), et
un composant d'entraînement (B9) prévu sur le support (B5) pour entraîner la tige filetée (B6) pour qu'elle tourne.

10. Robot de vérification de compteurs d'électricité selon la revendication 1, dans lequel la main mécanique comprend :
une base (D1),
une griffe intégrée (D2) prévue sur la base (D1) pour serrer une carte imprimée et un compteur d'électricité,
un dispositif de rotation du couvercle (D3) prévu sur la base (D1) pour ouvrir ou fermer un couvercle de programmation de compteur d'électricité, et
un dispositif de vissage (D4) prévu sur la base (D1) pour visser une vis et pour presser un bouton de programmation.

11. Robot de vérification de compteurs d'électricité selon la revendication 10, dans lequel la griffe intégrée (D2) comprend :
un premier doigt de serrage (D21) et un second doigt serrage (D22) permettant de serrer respectivement deux flancs du compteur d'électricité et de la carte imprimée, et
un second dispositif d'entraînement (D23) relié de manière fixe à la base (D1) pour entraîner le premier doigt de serrage (D21) et le second doigt de serrage (D22) pour qu'ils effectuent des mouvements de serrage.

12. Robot de vérification de compteurs d'électricité selon la revendication 11, dans lequel une première extrémité du premier doigt de serrage (D21) et munie d'une première extrémité de serrage de carte imprimée, et l'autre extrémité du premier doigt de serrage et munie d'une première extrémité de serrage de compteur d'électricité, et
une première extrémité du second doigt de serrage (D22) est munie d'une seconde extrémité de serrage de carte imprimée destinée à coopérer avec la première extrémité de serrage de carte imprimée afin de bloquer la carte imprimée, et l'autre extrémité du second doigt de serrage est munie d'une seconde extrémité de serrage de compteur d'électricité destinée à coopérer avec la première extrémité de serrage de compteur d'électricité afin de bloquer le compteur d'électricité.

13. Robot de vérification de compteurs d'électricité selon la revendication 12, dans lequel le dispositif de vissage (D4) comprend :
un tournevis correspondant à la vis située sur le couvercle de programmation du compteur d'électricité,
un élément d'entraînement prévu pour être fixe sur la base (D1) afin d'entraîner le tournevis en rotation, et
un composant de support, encliqueté à la griffe intégrée (D2) pour supporter le tournevis.

14. Robot de vérification de compteurs d'électricité selon la revendication 10, dans lequel le dispositif de rotation de couvercle (D3) comprend :
un disque d'aspiration (D31) destiné à aspirer le couvercle de programmation du compteur d'électricité,
un bras de fixation (D32) relié à la base (D1),
un bras tournant (D33) dont une première extrémité est articulée avec le bras de fixation (D32), et
un bras de raccordement (D34) articulé avec l'autre extrémité du bras tournant (D33) ; et le disque d'aspiration (D31) est prévu fixe à une extrémité du bras de raccordement (D34) à distance de bras tournant (D33).

15. Robot de vérification de compteurs d'électricité selon la revendication 10, dans lequel la main mécanique comprend en outre :
un dispositif de communication infrarouge (D5) prévu sur la base (D1) pour vérifier les performances de communication infrarouge du compteur d'électricité, et
un dispositif de capture vidéo (D6) prévu sur la base (D1) pour capturer des informations du compteur d'électricité.

16. Robot de vérification de compteurs d'électricité selon l'une quelconque des revendications 10 à 15, dans lequel la main mécanique comprend en outre un couvercle de protection (D7) prévu sur la base (D1), et le couvercle de protection (D7) est muni d'une extrémité de raccordement pour le relier au bras mécanique (C).

17. Robot de vérification de compteurs d'électricité selon la revendication 1, dans lequel le bras mécanique (C) comprend :
une première extrémité de raccordement reliée en pouvant tourner au châssis (A),
un premier bras de raccordement dont une première extrémité est articulée avec la première extrémité de raccordement,
une deuxième extrémité de raccordement articulée avec l'autre extrémité du premier bras de raccordement,
un second bras de raccordement relié en pouvant tourner à la deuxième extrémité de raccordement, et
une troisième extrémité de raccordement articulée avec le second bras de raccordement ; et la troisième extrémité de raccordement est reliée en pouvant tourner à la main mécanique (D).

18. Système de vérification de compteurs d'électricité, comprenant une plate-forme de vérification de compteurs d'électricité possédant un poste de vérification de compteurs d'électricité, le système de vérification de compteurs d'électricité comprenant en outre un robot de vérification de compteurs d'électricité conforme à l'une quelconque des revendications 1 à 17 ; et le robot de vérification de compteurs d'électricité fonctionne en coopération avec la plate-forme de vérification de compteurs d'électricité.
